# EUROPEAN PATENT APPLICATION

(11) **EP 4 683 440 A1**
(43) Date of publication of application: **21.01.2026**
(21) Application number: 24189009.4
(22) Date of filing: 16.07.2024
(51) Int. Cl.: H05K 7/14

(54) **MULTILAYER POSITIONING SYSTEM**

(71) Applicant: Aptiv Technologies AG, 8200 Schaffhausen (CH)
(72) Inventor: BARUS, Lukasz, 8200 Schaffhausen (CH); KUPCZYK, Pawel, 8200 Schaffhausen (CH); SWIERCZ, Karol, 8200 Schaffhausen (CH)
(74) Representative: Manitz Finsterwald Patent- und Rechtsanwaltspartnerschaft mbB

(57) **Abstract**

A multilayer positioning system includes at least one multidiameter pin and a housing. The at least one multidiameter pin includes at least two cylindrical sections, a first section having a first diameter and a second section having a second diameter. The first section is arranged at a first end of the multidiameter pin and the second section is arranged at a second end of the multidiameter pin. The at least one multidiameter pin is attached to the housing at the first end of the multidiameter pin. The first diameter of the first section is larger than the second diameter of the second section.

## Description

### FIELD

The present disclosure relates to a multilayer positioning system and a method for positioning multiple layers in a multilayer positioning system.

### BACKGROUND

Multilayer assemblies with parts stacked in one direction can be used in electronic devices in order to save space. For example, several printed circuit boards can be stacked in parallel in a housing to reduce required space for the housing of the electronic device in a vehicle.

Common solutions of multilayer assemblies may include multiple locators for each level keeping the next corresponding part in chain together. It is also possible to use a single locator pair for an entire stack but with a constant diameter over the entire assembly. Further, pin-hole and pin-slot features between two corresponding parts or layers may be used to stack and fix both layers together in different levels or datums.

However, stacking the layers can be prone to errors. For example, the layers can be stacked in the wrong order or with a wrong orientation. As a result, a correct assembly of the layers may not be guaranteed and additional measures may be required. In addition, tolerances of parts used by positioning systems can add up, which may lead to excessive space requirements in a housing of an electronic device.

Accordingly, there is a need for a multilayer positioning system that allows a correct positioning between layers in a multilayer stack and does not require excessive space in a housing of an electronic device.

### SUMMARY

The present disclosure provides a multilayer positioning system and a method for positioning multiple layers in a multilayer positioning system according to the independent claims. Embodiments are given in the subclaims, the description and the drawings.

In one aspect, the present disclosure is directed at a multilayer positioning system. The multilayer positioning system comprises at least one multidiameter pin comprising at least two cylindrical sections, a first section having a first diameter and a second section having a second diameter, wherein the first section is arranged at a first end of the multidiameter pin and the second section is arranged at a second end of the multidiameter pin. The multilayer positioning system further comprises a housing, wherein the at least one multidiameter pin is attached to the housing at the first end of the multidiameter pin. The first diameter of the first section is larger than the second diameter of the second section.

The multilayer positioning system may be configured to stack at least two layers in parallel and spaced apart to each other in the housing. The at least two layers may be stacked on two different levels or datums, wherein a datum is a flat plane. The number of layers that can be stacked using the multidiameter pin may depend on the number of cylindrical sections of the multidiameter pin. Each cylindrical section of the multidiameter pin may be configured to position only one layer in the housing. In particular, a multidiameter pin including two cylindrical sections may be configured to position two layers in parallel and spaced apart in the housing, wherein a multidiameter pin including three cylindrical sections may be configured to position three layers in parallel and spaced apart in the housing. A layer may be an element or a part that comprises electronic components.

It is to be understood that the at least two cylindrical sections may be substantially formed cylindrically, i.e. each of the at least two sections may alternatively be formed as a truncated cone, wherein a base diameter of the truncated cone is slightly larger than a top diameter of the truncated cone. Furthermore, it is also possible that each of the at least two sections may not have a circular base surface as in an embodiment of cylindrical sections, but alternatively the at least two sections may have an oval base surface, a racetrack shaped base surface or an angular base surface, for example a 3-cornered surface, a 6-cornered surface or a 9-cornered surface.

The first diameter of the first cylindrical section and the second diameter of the second cylindrical section may form a step between the first section and the second section of the multidiameter pin. A depth of the step between the first section and the second section may be half the difference between the first diameter and the second diameter. The step may be configured to hold a layer.

The first section of the multidiameter pin is arranged at the first end of the multidiameter pin and the second section of the multidiameter pin is arranged at the second end of the multidiameter pin, wherein the first end and the second end are arranged opposite each other.

The at least one multidiameter pin is attached to the housing at the first end of the multidiameter pin, in particular the at least one multidiameter pin is attached to a ground plate of the housing at the first end of the multidiameter pin. The first section at the first end of the multidiameter pin may be attached to the ground plate of the housing. The housing may be configured to position a plurality of layers stacked in parallel and spaced apart by the multidiameter pin in the housing.

According to an embodiment, the at least one multidiameter pin further comprises a third cylindrical section having a third diameter, wherein the third cylindrical section is arranged between the first section at the first end of the multidiameter pin and the second section at the second end of the multidiameter pin, the third diameter is smaller than the first diameter and larger than the second diameter. The first diameter of the first section, the second diameter of the second section and the third diameter of the third section taper from the first end of the multidiameter pin to the second end of the multidiameter pin. Thus, the first diameter of the first section is the largest diameter and the second diameter of the second section is the smallest diameter of the first diameter, the second diameter and the third diameter.

The first diameter of the first cylindrical section and the third diameter of the third cylindrical section may form a step between the first section and the third section of the multidiameter pin. A depth of the step between the first section and the third section may be half the difference between the first diameter and the third diameter. Also, the third diameter of the third cylindrical section and the second diameter of the second cylindrical section may form a step between the third section and the second section of the multidiameter pin. A depth of the step between the third section and the second section may be half the difference between the third diameter and the second diameter. Each of the steps may be configured to hold a layer. The multidiameter pin according to this embodiment may be configured to position three layers in parallel and spaced apart in the housing.

According to an embodiment, the at least one multidiameter pin is configured to position at least one layer comprising a hole, wherein the hole of the at least one layer has a diameter corresponding to at least one of the first diameter of the first section or the second diameter of the second section of the multidiameter pin. The at least one layer may only be arrangeable on one section of the multidiameter pin. Each cylindrical section of the multidiameter pin may be configured to position only one layer in the housing. Each layer of the at least one layer may only be positioned on that section of the multidiameter pin that has the same diameter as the hole of the at least one layer, i.e. the hole with the diameter that fits to the hole of the layer. The at least one layer may include as many holes as there are multidiameter pins, wherein each hole may be assigned to a respective section of the multidiameter pin. Each hole of the at least one layer may have the same diameter. Thus, the layer may be positioned by the same section of each respective multidiameter pin.

According to this embodiment, the at least one layer is a printed circuit board. The printed circuit board may be an element or a part used to connect electronic components to one another in a circuit. The printed circuit board may be formed as a plane board, wherein electrical components may be fixed to conductive pads on outer layers of the board.

According to an embodiment, the multidiameter pin comprises a conically shaped tip at the second end of the multidiameter pin. The conically shaped tip at the second end of the multidiameter pin may be configured to thread the multidiameter pin into a hole of a layer. Therefore, an easier assembly of the layer to the multidiameter pin may be obtained. The tip at the second end of the multidiameter pin may additionally be rounded. Thus, a damage to the layer when inserting it in the multidiameter pin may be avoided.

According to an embodiment, the multidiameter pin comprises a truncated cone between the first section of the multidiameter pin and the second section of the multidiameter pin. The truncated cone may improve a transition from the first section of the multidiameter pin to the second section of the multidiameter pin. In particular, an insertion of a layer into the multidiameter pin that fits into the first section of the multidiameter pin may be improved, i.e. a diameter of a hole of the layer is substantially equal to the first diameter of the first section. The layer may slide along the truncated cone from the second section to the first section if the layer is to be positioned on the first section.

According to this embodiment, a base diameter of the truncated cone is equal to the first diameter of the first section and a top diameter of the truncated cone is equal to the second diameter of the second section. In particular, a circular edge with the base diameter at a base of the truncated cone coincides with a circular edge with the first diameter of the first section of the multidiameter pin. A circular edge with the top diameter at a top of the truncated cone coincides with a circular edge with the second diameter of the second section of the multidiameter pin.

According to an embodiment, the multidiameter pin comprises a first rounded edge between the first section and the truncated cone and a second rounded edge between the truncated cone and the second section. The first rounded edge between the first section and the truncated cone may be designed as a convex surface. The second rounded edge between the truncated cone and the second section may be designed as a concave surface. A transition between the first section of the multidiameter pin and the second section of the multidiameter pin may be further improved by the first rounded edge and the second rounded edge. This may further facilitate a stacking of layers on the multidiameter pin.

According to an embodiment, the multilayer positioning system further comprises a pedestal, wherein the pedestal is arranged between the housing and the first section at the first end of the multidiameter pin. In particular, the pedestal may be arranged on a ground plate of the housing. The pedestal may be cylindrical in shape. The first section of the multidiameter pin may be attached to the pedestal.

The pedestal may be used to create more space between a first layer, which may be positioned at the first section of the multidiameter pin, and the housing.

According to an embodiment, the first diameter is in a range between 3-7 mm, preferably between 4-6 mm, in particular 4,8 mm. The first diameter may comprise a tolerance of 0,03 to 0,07 mm, in particular 0,05 mm. Thus, the first diameter may be in a range between 2,95-7,05 mm, preferably between 3,95-6,05 mm, in particular 4,75-4,85 mm.

According to an embodiment, the second diameter is in a range between 1-5 mm, preferably between 2-4 mm, in particular 2,8 mm. The second diameter may comprise a tolerance of 0,03 to 0,07 mm, in particular 0,05 mm. Thus, the second diameter may be in a range between 0,95-5,05 mm, preferably between 1,95-4,05 mm, in particular 2,75-2,85 mm.

According to an embodiment, the third diameter is in a range between 2-6 mm, preferably between 3-5 mm, in particular 3,8 mm. The third diameter may comprise a tolerance of 0,03 to 0,07 mm, in particular 0,05 mm. Thus, the third diameter may be in a range between 1,95-6,05 mm, preferably between 2,95-5,05 mm, in particular 3,75-3,85 mm.

The tolerances of the first diameter of the first section, the second diameter of the second section and the third diameter of the third section of the multidiameter pin may be configured to fix a first layer to the first section of the multidiameter pin, a second layer to the second section of the multidiameter pin and a third layer to the third section of the multidiameter pin.

According to an embodiment, the first section of the multidiameter pin and the second section of the multidiameter pin are arranged coaxially. The first section of the multidiameter pin and the second section of the multidiameter pin may have a common rotational axis. The second section of the multidiameter pin may be arranged above the first section of the multidiameter pin.

According to an embodiment, respective centerlines of the first section of the multidiameter pin and of the second section of the multidiameter pin are arranged perpendicular to the housing. A centerline of the first section of the multidiameter pin and a centerline of the second section of the multidiameter pin may be arranged collinear. The centerline of the first section of the multidiameter pin may be a rotational axis of the first section of the multidiameter pin. The centerline of the second section of the multidiameter pin may be a rotational axis of the second section of the multidiameter pin.

The respective centerlines of the first section of the multidiameter pin and of the second section of the multidiameter pin may form the common rotational axis of the multidiameter pin. The at least one multidiameter pin may be attached perpendicular to a ground plate of the housing. Thus, the common rotational centerline of the multidiameter pin and/or the centerline of the first section and the centerline of the second section may be perpendicular arranged to a surface of the ground plate of the housing.

The respective centerlines of the first section, the second section and the third section may comprise a tolerance of 0,1-0,3 mm, in particular of 0,2 mm with respect to each other. In other words, the centerline of the fist section may deviate from the centerline of the second section by a maximum of 0,1-0,3 mm, in particular by 0,2 mm. Accordingly, the centerline of the first section may deviate from the centerline of the third section by a maximum of 0,1-0,3 mm, in particular by 0,2 mm, and the centerline of the second section may deviate from the centerline of the third section by a maximum of 0,1-0,3 mm, in particular by 0,2 mm. Thus, overall tolerances of the multilayer positioning system may be limited and a plurality of layer may be properly stacked on top of each other.

In another aspect, the present disclosure is directed at a method of positioning multiple layers in a multilayer positioning system as described herein. The method comprises the following steps: positioning a first layer at a first section of a multidiameter pin in the multilayer positioning system by attaching the first layer to the first section of the multidiameter pin of the multilayer positioning system, in particular by threading the multidiameter pin into a hole of the first layer; and positioning a second layer at a second section of the multidiameter pin in the multilayer positioning system by attaching the second layer to the second section of the multidiameter pin of the multilayer positioning system, in particular by threading the multidiameter pin into a hole of the second layer, wherein a diameter of the hole of the first layer corresponds to a diameter of the first section of the multidiameter pin and a diameter of a hole of the second layer corresponds to a diameter of the second section of the multidiameter pin, and wherein the first diameter of the first section is larger than the second diameter of the second section.

### DRAWINGS

Exemplary embodiments and functions of the present disclosure are described herein in conjunction with the following drawings, showing schematically:
- Fig. 1: a multilayer positioning system;
- Fig. 2: a multidiameter pin;
- Fig. 3: a multidiameter pin of a multilayer positioning system positioning multiple layers; and
- Fig. 4: a flow diagram illustrating a method for positioning multiple layers in a multilayer positioning system.

### DETAILED DESCRIPTION

The problem of proper positioning between parts in multilayer stack that does not use excessive space in unit, incorporates poka-yoke and improves stacking tolerance may be solved by a multilayer positioning system, also called multilevel positioning system, as described herein.

The multilayer positioning system may include at least one, in particular two_{[KP1]} multidiameter pins corresponding with proper holes in parts or layers that can be stacked by the at least one, in particular two multidiameter pins. The multilayer positioning system is described with reference to one multidiameter pin. However, it is to be understood that all features described for the one multidiameter pin may also apply to further multidiameter pins of the multilayer positioning system.

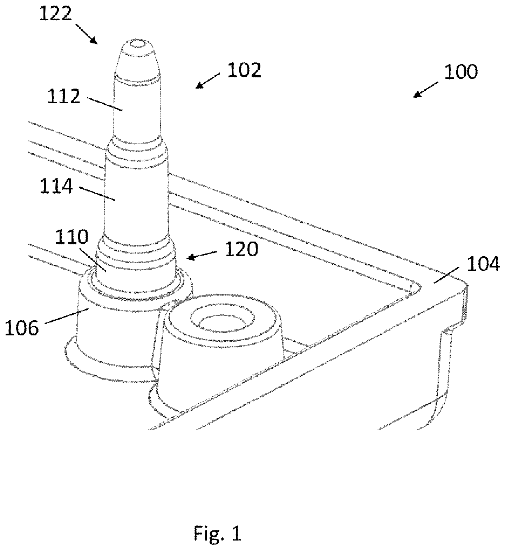

Fig. 1 shows a multilayer positioning system 100. The multilayer positioning system 100 includes a multidiameter pin 102. The multidiameter pin 102 includes three cylindrical sections 110, 112, 114. A first cylindrical section 110 of the multidiameter pin 102 has a first diameter, a second cylindrical section 112 has a second diameter, and a third cylindrical section 114 has a third diameter, wherein the first cylindrical section 110 is arranged at a first end 120 of the multidiameter pin 102, the second cylindrical section 112 is arranged at a second end 122 of the multidiameter pin 102, and the third cylindrical section 114 is arranged between the first end 120 of the multidiameter pin 102 and the second end 122 of the multidiameter pin 102.

The multilayer positioning system 100 includes a housing 104. The multidiameter pin 102 is attached to the housing 104 at the first end 120 of the multidiameter pin 102. In particular, the multilayer positioning system 100 according to this embodiment includes a pedestal 106, wherein the pedestal 106 is arranged between the housing 104 and the first section 110 at the first end 120 of the multidiameter pin 102. The pedestal 106 is attached to the housing 104. Thus, the multidiameter pin 102 is attached to the housing 104 via the pedestal 106.

The first diameter of the first section 110, the second diameter of the second section 112 and the third diameter of the third section 114 are decreasing from the first end 120 to the second end 122 of the multidiameter pin 102.

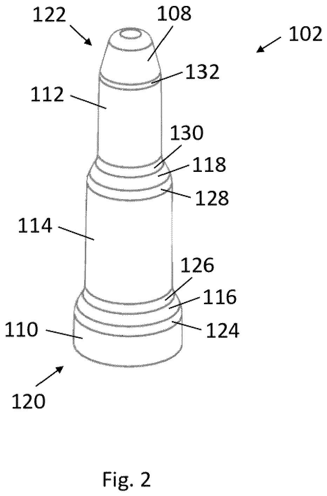

Fig. 2 shows a multidiameter pin 102. The multidiameter pin 102 includes a first truncated cone 116 arranged between the first section 110 of the multidiameter pin 102 and the third section 114 of the multidiameter pin 102. A base diameter of the first truncated cone 116 coincides with the first diameter of the first section 110 and a top diameter of the first truncated cone 116 coincides with the third diameter of the third section 114. The multidiameter pin 102 further includes a first rounded edge 124 arranged between the first section 110 and the first truncated cone 116 and a second rounded edge 126 arranged between the first truncated cone 116 and the third section 114. The first rounded edge 124 may be formed as a convex surface and the second rounded edge 126 may be formed as a concave surface.

The multidiameter pin 102 further includes a second truncated cone 118 arranged between the second section 112 of the multidiameter pin 102 and the third section 114 of the multidiameter pin 102. A base diameter of the second truncated cone 118 coincides with the third diameter of the third section 114 and a top diameter of the second truncated cone 118 coincides with the second diameter of the second section 114. The multidiameter pin 102 includes a third rounded edge 128 arranged between the third section 114 and the second truncated cone 118 and a fourth rounded edge 130 arranged between the second truncated cone 118 and the second section 112. The third rounded edge 128 may be formed as a convex surface and the fourth rounded edge 130 may be formed as a concave surface.

The multidiameter pin 102 further includes a conically shaped tip 108 at the second end 122 of multidiameter pin 102. A base diameter at one end of the conically shaped tip 108 coincides with the second diameter of the second section 112. Another end of the conically shaped tip 108, oppositely arranged to the one end of the conically shaped tip 108, is rounded off. An edged 132 between the second section 112 and the one end of the conically shaped tip 108 may be rounded. The rounded edge 132 may be formed as a convex surface.

The first diameter may be in a range between 3-7 mm, preferably between 4-6 mm, in particular 4,8 mm. The second diameter may be in a range between 1-5 mm, preferably between 2-4 mm, in particular 2,8 mm. The third diameter may be in a range between 2-6 mm, preferably between 3-5 mm, in particular 3,8 mm.

A height of the respective first section 110, the second section 112 and the third section 114 may be in a range between 1-10 mm, preferably between 3-8 mm, in particular 5 mm.

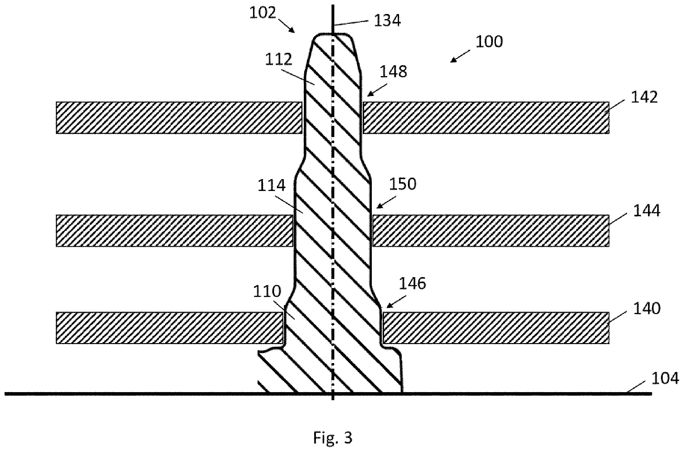

Fig. 3 shows a multidiameter pin 102 of a multilayer positioning system 100 positioning multiple layers 140, 142, 144. The first section 110 of the multidiameter pin 102, the second section 112 of the multidiameter pin 102 and the third section 114 of the multidiameter pin 102 may include a centerline 134. The respective centerlines 134 may define an axis of symmetry of the cylindrical first section 110, the cylindrical second section 112 and the cylindrical third section 114. The respective centerlines 134 of the first section 110, the second section 112 and the third section 114 are collinear arranged. The respective centerlines 134 of the first section 110, the second section 112 and the third section 114 are perpendicular arranged to the housing 104 of the multilayer positioning system 100.

The multidiameter pin 102 is configured to position at least one layer 140, 142, 144 including a hole 146, 148, 150, wherein the respective hole 146, 148, 150 of the at least one layer 140, 142, 144 has a diameter corresponding to at least one of the first diameter of the first section 110, the second diameter of the second section 112 or the third diameter of the third section 114 of the multidiameter pin 102. The at least one layer 140, 142, 144 may be a printed circuit board.

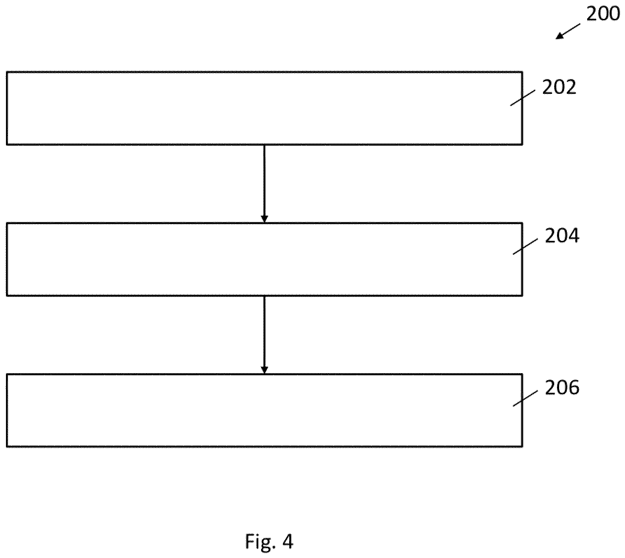

Fig. 4 shows a flow diagram 200 illustrating a method for positioning multiple layers in a multilayer positioning system 100. At 202, positioning 202 a first layer 140 at a first section 110 of a multidiameter pin 102 in the multilayer positioning system 100 by attaching the first layer 140 to the first section 110 of the multidiameter pin 102 of the multilayer positioning system 100. In particular, the first layer 140 may be attached to the first section 110 of the multidiameter pin 102 by threading the multidiameter pin 102 into a hole 146 of the first layer 140. A diameter of the hole 146 of the first layer 140 corresponds to a diameter of the first section 110 of the multidiameter pin 102.

At 204, positioning (204) a third layer 144 at a third section114 of the multidiameter pin 102 in the multilayer positioning system 100 by attaching the third layer 144 to the third section 114 of the multidiameter pin 102 of the multilayer positioning system 100. In particular, the third layer 144 may be attached to the third section 114 of the multidiameter pin 102 in the multilayer positioning system 100 by threading the multidiameter pin 102 into a hole 150 of the third layer 144. A diameter of the hole 150 of the third layer 144 corresponds to a diameter of the third section 114 of the multidiameter pin 102.

At 206, positioning 206 a second layer 142 at a second section 112 of the multidiameter pin 102 in the multilayer positioning system 100 by attaching the second layer 142 to the second section 112 of the multidiameter pin 102 of the multilayer positioning system 100. In particular, the second layer 142 may be attached to the second section 112 of the multidiameter pin 102 in the multilayer positioning system 100 by threading the multidiameter pin 102 into a hole 148 of the second layer 142. A diameter of the hole 148 of the second layer 142 corresponds to a diameter of the second section 112 of the multidiameter pin 102. The first diameter of the first section 110 is larger than the third diameter of the third section 114, and the third diameter of the third section 114 is larger than the second diameter of the second section 112.

To summarize, a multilevel or multilayer positioning system as described herein may include at least one multidiameter pin. The at least one multidiameter pin may include at least two cylindrical sections having different diameters. The diameters of the cylindrical sections may decrease from a bottom at the first end of the multidiameter pin towards a top at the second end of the multidiameter pin. Each diameter of a section of the multidiameter pin may define a level and may be designated to be used to position one particular corresponding part, for example a layer or a printed circuit board, in the multilayer positioning system.

Corresponding parts may be placed only in proper order on the at least one multidiameter pin, one on top of the other. This may be possible by matching a respective hole diameter of a layer with a corresponding diameter of a section of the multidiameter pin. Otherwise, an excessive play may occur if a diameter of the hole is larger than the corresponding diameter of the section of the multidiameter pin, or inserting the corresponding part into place at the multidiameter pin may be impossible if the diameter of the hole is smaller than the corresponding diameter of the section of the multidiameter pin.

Applications with a multilayer positioning system including a multidiameter pin as describe herein may benefit from in-unit and on-board spatial packaging savings as a whole. The multilayer positioning system is not multiplied by each pair of elements or part that need to be stacked. Also, it is easier to manufacture and maintain tolerance by keeping it limited to one feature.

The multilayer positioning system as described herein keeps a multilevel system or a whole datum system of stacked layers in one place although several elements or layers must be positioned in the stack, and also includes poka-yoke features, wherein a poka-yoke feature may be any mechanism in a process that helps an equipment operator avoid mistakes and defects by preventing, correcting, or drawing attention to human errors as they occur.

### Reference numeral list

- 100: multilayer positioning system
- 102: multidiameter pin
- 104: housing
- 106: pedestal
- 108: tip
- 110: first section
- 112: second section
- 114: third section
- 116: truncated cone
- 118: truncated cone
- 120: first end
- 122: second end
- 124: rounded edge
- 126: rounded edge
- 128: rounded edge
- 130: rounded edge
- 132: rounded edge
- 134: centerline

- 140: first layer
- 142: second layer
- 144: third layer
- 146: hole
- 148: hole
- 150: hole
- 200: method for positioning multiple layers in a multilayer positioning system
- 202: step of positioning a first layer to the multilayer positioning system
- 204: step of positioning a third layer to the multilayer positioning system
- 206: step of positioning a second layer to the multilayer positioning system

## Claims

1. Multilayer positioning system (100), comprising:
- at least one multidiameter pin (102) comprising at least two cylindrical sections (110, 112), a first section (110) having a first diameter and a second section (112) having a second diameter, wherein the first section (110) is arranged at a first end (120) of the multidiameter pin (102) and the second section (112) is arranged at a second end (122) of the multidiameter pin (102); and
- a housing (104), wherein the at least one multidiameter pin (102) is attached to the housing (104) at the first end (120) of the multidiameter pin (102),
wherein the first diameter of the first section (110) is larger than the second diameter of the second section (112).

2. Multilayer positioning system (100) according to claim 1,
wherein the at least one multidiameter pin (102) further comprises a third cylindrical section (114) having a third diameter, wherein the third cylindrical section (114) is arranged between the first section (110) at the first end (120) of the multidiameter pin (102) and the second section (112) at the second end (122) of the multidiameter pin (102), the third diameter is smaller than the first diameter and larger than the second diameter.

3. Multilayer positioning system (100) according to at least one of claims 1 or 2, wherein the at least one multidiameter pin (102) is configured to position at least one layer (140, 142, 144) comprising a hole (146, 148, 150), wherein the hole (146, 148, 150) of the at least one layer (140, 142, 144) has a diameter corresponding to at least one of the first diameter of the first section (110) or the second diameter of the second section (112) of the multidiameter pin (102).

4. Multilayer positioning system (100) according to claim 3,
wherein the at least one layer (140, 142, 144) is a printed circuit board.

5. Multilayer positioning system (100) according to at least one of claims 1 to 4, wherein the multidiameter pin (102) comprises a conically shaped tip (108) at the second end (122) of the multidiameter pin (102).

6. Multilayer positioning system (100) according to at least one of claims 1 to 5, wherein the multidiameter pin (102) comprises a truncated cone (116) between the first section (110) of the multidiameter pin (102) and the second section (112) of the multidiameter pin (102).

7. Multilayer positioning system (100) according to claim 6,
wherein a base diameter of the truncated cone (116) is equal to the first diameter of the first section (110) and a top diameter of the truncated cone (116) is equal to the second diameter of the second section (112).

8. Multilayer positioning system (100) according to at least one of claims 6 or 7, wherein the multidiameter pin (102) comprises a first rounded edge (124) between the first section (110) and the conical truncated cone (116) and a second rounded edge (126) between the conical truncated cone (116) and the second section (112).

9. Multilayer positioning system (100) according to at least one of claims 1 to 8, further comprising:
- a pedestal (106), wherein the pedestal (106) is arranged between the housing (104) and the first section (110) at the first end (120) of the multidiameter pin (102).

10. Multilayer positioning system (100) according to at least one of claims 1 to 9, wherein the first diameter is in a range between 3-7 mm, preferably between 4-6 mm, in particular 4,8 mm.

11. Multilayer positioning system (100) according to at least one of claims 1 to 10, wherein the second diameter is in a range between 1-5 mm, preferably between 2-4 mm, in particular 2,8 mm.

12. Multilayer positioning system (100) according to at least one of claims 2 to 11, wherein the third diameter is in a range between 2-6 mm, preferably between 3-5 mm, in particular 3,8 mm.

13. Multilayer positioning system (100) according to at least one of claims 1 to 12, wherein the first section (110) of the multidiameter pin (102) and the second section (112) of the multidiameter pin (102) are arranged coaxially.

14. Multilayer positioning system (100) according to at least one of claims 1 to 13, wherein respective centerlines (134) of the first section (110) of the multidiameter pin (102) and of the second section (112) of the multidiameter pin (102) are arranged perpendicular to the housing (104).

15. A method for positioning multiple layers (140, 142, 144) in a multilayer positioning system (100) according to at least one of claims 1 to 14, comprising the following steps:
- positioning (202) a first layer (140) at a first section (110) of a multidiameter pin (102) in the multilayer positioning system (100) by attaching the first layer (140) to the first section (110) of the multidiameter pin (102) of the multilayer positioning system (100), in particular by threading the multidiameter pin (102) into a hole (146) of the first layer (140); and
- positioning (204) a second layer (142) at a second section (112) of the multidiameter pin (102) in the multilayer positioning system (100) by attaching the second layer (142) to the second section (112) of the multidiameter pin (102) of the multilayer positioning system (100), in particular by threading the multidiameter pin (102) into a hole (148) of the second layer (142),
wherein a diameter of the hole (146) of the first layer (140) corresponds to a diameter of the first section (110) of the multidiameter pin (102) and a diameter of a hole (148) of the second layer (142) corresponds to a diameter of the second section (112) of the multidiameter pin (102), and
wherein the first diameter of the first section (110) is larger than the second diameter of the second section (112).
